# EUROPEAN PATENT APPLICATION

(11) **EP 4 177 384 A1**
(43) Date of publication of application: **10.05.2023**
(21) Application number: 21831686.7
(22) Date of filing: 18.05.2021
(51) Int. Cl.: C30B 29/38, H01L 21/205

(54) **LARGE-DIAMETER SUBSTRATE FOR GROUP-III NITRIDE EPITAXIAL GROWTH AND METHOD FOR PRODUCING THE SAME**

(30) Priority: 01.07.2020 JP 2020114475
(71) Applicant: SHIN-ETSU CHEMICAL CO., LTD., Tokyo 1000005 (JP); Shin-Etsu Handotai Co., Ltd., Tokyo 100-0004 (JP)
(72) Inventor: KUBOTA, Yoshihiro, Annaka-shi, Gunma 379-0195 (JP); KAWAHARA, Minoru, Tokyo 100-0005 (JP); YAMADA, Masato, Tokyo 100-0004 (JP)
(74) Representative: Vossius & Partner Patentanwälte Rechtsanwälte mbB
(86) International application number: PCT/JP2021/018734
(87) International publication number: WO 2022/004165

(57) **Abstract**

A substrate for group-III nitride epitaxial growth and a method for producing the same are provided, which are capable of fabricating a high-quality group III nitride single crystal at low cost.

The substrate for group-III nitride epitaxial growth according to the present invention comprises: a supporting substrate having a structure in which a core consisting of nitride ceramics is wrapped in an encapsulating layer having a thickness of between 0.05 um and 1.5 um, inclusive; a planarizing layer provided on an upper surface of the supporting substrate, the planarizing layer having a thickness of between 0.5 µm and 3.0 µm, inclusive; and a seed crystal layer consisting of a single crystal with a thickness of between 0.1 µm and 1.5 um, inclusive, provided on an upper surface planarizing layer and having an uneven pattern on the surface.

## Description

### TECHNICAL FIELD

The present invention relates to seed substrates used for epitaxial growth of single crystals of group III nitrides, such as aluminum nitride (AlN), aluminum gallium nitride (AlₓGa₁₋ₓN (however, 0 < x < 1.0)), and gallium nitride (GaN) .

### BACKGROUND ART

Substrates of group III nitrides, such as crystalline AlN and GaN, have a wide bandgap, and possess short wavelength luminescence, high breakdown voltage, and excellent high-frequency characteristics. For this reason, group III nitride substrates are expected to be applied to devices such as light-emitting diodes (LEDs), lasers, Schottky diodes, power devices, and high-frequency devices. In particular, bactericidal effects have been reported in the emission wavelength in the deep ultraviolet range (UVC; 200 to 280 nm) of LEDs fabricated from single crystals of AlN and AlₓGa₁₋ₓN (0.5 < x < 1.0) (Non-Patent Document 1), and a further improvement in quality, increase in diameter, and reduction in cost, are desired.

Since AlN does not have a melting point under normal pressure, the production with the melt method commonly used for silicon single-crystals, or the like, is difficult.

Non-Patent Documents 2 and 3 describe a method of producing an AlN single crystal substrate by using a sublimation method (improved Rayleigh method) using SiC or AlN as seed crystals in an N₂ atmosphere at 1700 to 2250°C. However, due to equipment limitations, such as hightemperature requirements for crystal growth, it is difficult to reduce the cost, and it is also difficult to achieve a large diameter of φ 4-inch or larger.

Patent Document 1 describes a method for growing an AlN layer by using a hydride vapor deposition (HVPE) method using a silicon substrate or an AlN substrate as a base substrate. However, in this method, it is difficult to reduce the dislocation density of the AlN layer due to the difference in lattice constant or thermal expansion coefficient when silicon is used for the base substrate. On the other hand, using an AlN substrate obtained by using the sublimation method with good crystallinity as a base substrate reduces dislocation density, but it is difficult to reduce the cost of large-diameter substrates because the base substrate itself is small in diameter and expensive. To compensate for these shortcomings, non-patent document 4 discloses a method of depositing a 5 µm of AlN film on a sapphire substrate that serves as both base and seed substrate by batch MOVPE method, followed by etching to create grooves in the film and then further depositing the desired thickness of AlN layer by HVPE method. The above groove structure allows the voids formed during HVPE deposition to act as a relieving layer for stress due to thermal expansion differences, thus preventing cracking. However, this is effective only when the base substrate is φ 4-inch or smaller, and when the base substrate is φ 6-inch, φ 8-inch, φ 12-inch or larger in diameter, cracks and large warping occur, which is a problem.

Patent document 2 describes a method for epitaxial growth of group III nitrides such as GaN single crystals using a composite substrate with a thin film of silicon <111> single crystal transferred onto a base substrate encapsulated by Si₃N₄ or the like as a seed crystal. In this method, AlN ceramics, which has a thermal expansion coefficient close to that of AlN single crystal and is low cost, is used as the base substrate. However, when epitaxial deposition of a single crystal of AlN or AlₓGa₁₋ₓN (0 < x < 1) is performed using this method, for example, it is difficult to reduce the dislocation density due to the difference in lattice constants between the silicon <111> seed crystal and the target single crystal of AlN or AlₓGa₁₋ₓN (0 < x < 1). It is also difficult to reduce the cracks and warpage of the deposited substrate due to the affinity with an encapsulating layer, a planarization layer, etc. and the difference in thermal expansion coefficient. These factors affect the degradation of properties and lower yields in device fabrication in the downstream process and have consequently hindered improvement in quality and cost reduction of lasers, LEDs, high-frequency devices, and other products to be fabricated.

Hence, in order to eliminate such shortcomings, the inventors and the like have diligently conducted examinations and come to the present invention.

### PRIOR ART REFERENCES

### PATENT DOCUMENTS

Patent Document 1: JP4565042B
Patent Document 2: JP6626607B

### NON-PATENT DOCUMENTS

Non-Patent Document 1: LEDs Magazine Japan; December 2016, pp. 30-31
Non-Patent Document 2: SEI Technical Review; No. 177, pp. 88-91
Non-Patent Document 3: Fujikura Technical Review; No. 119, 2010, Vol. 2, pp. 33-38
Non-Patent Document 4: Journal of Crystal Growth 411 (2015), p38-p44

### SUMMARY OF THE INVENTION

### PROBLEMS TO BE SOLVED BY THE INVENTION

The present invention has been made in light of the above circumstances, and an object thereof is to provide a substrate for group III nitride epitaxial growth that is capable of fabricating single crystals of group III nitrides, in particular, AlN or AlₓGa₁₋ₓN (0.5 < x < 1.0), with large diameter, high quality and at low cost, which are suitable for use in light-emitting diodes in the deep ultraviolet range (UVC; 200 to 280 nm), and a method for producing the same.

### MEANS FOR SOLVING THE PROBLEMS

The inventors, as a result of many trials, have invented a substrate for group III nitride epitaxial growth that does not crack or warp even in large diameters, concentrates crystal defects at the sides during deposition, and enables high-purity, high-quality epitaxial crystal growth, as well as a method for manufacturing the substrate by (1), (2), and (3) below.
(1) The substrate comprises a supporting substrate having a structure in which a core consisting of nitride ceramics is wrapped in an encapsulating layer having a thickness of between 0.05 µm and 1.5 um; inclusive;
   a planarizing layer provided on an upper surface of the supporting substrate, the planarizing layer having a thickness of between 0.5 um and 3.0 µm, inclusive; and
   a seed crystal layer of a single crystal with a thickness of between 0.1 µm and 1.5 um, inclusive, provided on an upper surface planarizing layer and having an uneven pattern on the surface.
(2) The support substrate (base substrate) and the epitaxial film have the same thermal expansion coefficient.
(3) Periodic grooves, dot structures, or 0.1-3° off-angle uneven patterns are formed on the thin-film transferred seed crystal surface. The present invention is effective through the individual elements (1), (2), and (3) above, but when all three are present, the synergistic effect is extremely remarkable.

In order to solve the above problem, the substrate for group-III nitride epitaxial growth in accordance with the embodiment of the present invention comprises: a supporting substrate having a structure in which a core consisting of nitride ceramics is wrapped in an encapsulating layer having a thickness of between 0.05 um and 1.5 um, inclusive; a planarizing layer provided on an upper surface of the supporting substrate, the planarizing layer having a thickness of between 0.5 µm and 3.0 µm, inclusive; and a seed crystal layer consisting of a single crystal with a thickness of between 0.1 µm and 1.5 µm, inclusive, provided on an upper surface planarizing layer and having an uneven pattern on the surface.

In the present invention, a substrate for group III nitride epitaxial growth may further include a stress-adjusting layer on the bottom surface of the supporting substrate.

In the present invention, the core may be aluminum nitride ceramics. In addition, the encapsulating layer may contain silicon nitride. In addition, the planarizing layer may contain any one of silicon oxide, silicon oxynitride, and aluminum arsenide. In addition, the stress-adjusting layer may contain simple substance silicon.

In the present invention, the seed crystal layer may be Si <111>, SiC, sapphire, aluminum nitride, or aluminum gallium nitride. And it is preferred that the uneven pattern of the seed crystal layer is selected from periodic grooves, off-angles of 0.1 to 3°, and dot structures. When the seed crystal layer is aluminum nitride or aluminum gallium nitride, it is preferable that the resistivity is 1 × 10⁶ Ω·cm or higher.

A method for producing a substrate for group-III nitride epitaxial growth in accordance with the embodiment of the present invention comprises steps of: preparing a core consisting of nitride ceramics; obtaining a supporting substrate by depositing an encapsulating layer so as to wrap the core, the encapsulating layer having a thickness of between 0.05 µm and 1.5 µm, inclusive; depositing a planarizing layer on an upper surface of the supporting substrate, the planarizing layer having a thickness of between 0.5 um and 3.0 µm, inclusive; and providing a seed crystal layer consisting of a single crystal with a thickness of between 0.1 µm and 1.5 um, inclusive, provided on an upper surface planarizing layer and having an uneven pattern on the surface.

The method for producing a substrate for group III nitride epitaxial growth may further include a step of depositing a stress-adjusting layer on the bottom surface of the supporting substrate.

In the present invention, the encapsulating layer may be deposited by using an LPCVD method. In addition, the planarizing layer may be deposited by using any one of a plasma CVD method, an LPCVD method, and a low-pressure MOCVD method.

In the present invention, the step of providing a seed crystal layer may include the steps of: preparing a single crystal substrate of a group III nitride, one surface of the single crystal substrate being an ion implantation surface; forming a peeling position in the single crystal substrate by performing ion implantation from the ion implantation surface; obtaining a bonded substrate by bonding the ion implantation surface and the planarizing layer; separating the bonded substrate into the seed crystal layer and a remaining section of the single crystal substrate at the peeling position; and providing the uneven pattern on the seed crystal layer obtained in the above.

In this invention, in the step of preparing a single crystal substrate, Si<111>, SiC, or sapphire substrates, which are easy to obtain as commercial substrates with a large diameter, can be used as they are. On the other hand, for aluminum nitride or aluminum gallium nitride, for which large-diameter substrates are difficult to obtain, a single-crystal large-diameter substrate can be made by laminating aluminum nitride or aluminum gallium nitride on a large-diameter sapphire substrate by MOCVD, HVPE, or THVPE method. Alternatively, single crystal substrate may be obtained by bonding small-diameter single crystals made by epitaxial growth of an epitaxial layer of aluminum nitride or aluminum gallium nitride by either the HVPE, HVPE, and THVPE methods on a substrate of small-diameter single crystal made by the sublimation method or on an AlN substrate made by the sublimation method.

If the epitaxial layer is laminated on the single crystal substrate, the peeling position may be formed within the epitaxial layer in the step of forming the peeling position. In this case, the remaining section of the single crystal substrate may be reused as the base substrate. Alternatively, the remaining section of the single crystal substrate may be reused as a single crystal substrate in the production of a further different group III nitride composite substrate.

In the present invention, the core may be aluminum nitride ceramics. In addition, the encapsulating layer may contain silicon nitride. In addition, the planarizing layer may contain any one of silicon oxide, silicon oxynitride, and aluminum arsenide. In addition, the stress-adjusting layer may contain simple substance silicon.

In the present invention, the seed crystal layer may be Si<111>, SiC, aluminum nitride, or aluminum gallium nitride. The seed crystal layer may be provided with an uneven pattern. The uneven pattern is preferably selected from periodic grooves, off-angles of 0.1 to 3°, and dot structures. In addition, the resistivity of the seed crystal layer is preferably 1 × 10⁶ Ω·cm or more.

### EFFECT OF THE INVENTION

According to the present invention, a substrate for group III nitride epitaxial growth, which is capable of producing a high-quality and large-diameter group III nitride single crystal at low cost, can be provided.

### BRIEF DESCRIPTION OF THE DRAWINGS

FIG. 1 is a diagram showing the cross-sectional structure of a composite substrate 1.
FIG. 2 is a diagram showing the procedure for producing the composite substrate 1.
FIG. 3 is a schematic diagram showing a substrate fabricated by using a sublimation method used as a single-crystal substrate 20.
FIG. 4 is a schematic diagram showing the structure of a single-crystal epitaxial layer substrate used as the single-crystal substrate 20.

### EMBODIMENTS OF THE INVENTION

The embodiments of the present invention will be described in detail hereinafter, but the present invention is not limited thereto.

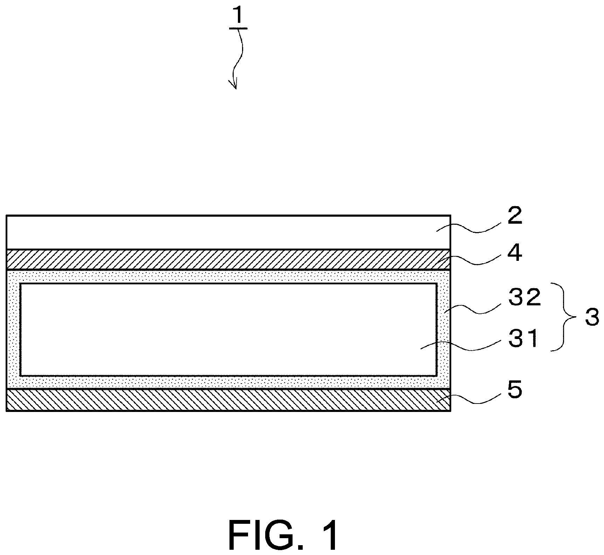

FIG. 1 shows the cross-sectional structure of a composite substrate 1 according to the present embodiment. The composite substrate 1 shown in FIG. 1 has a structure in which a planarizing layer 4 and a seed crystal layer 2 of a single crystal having an uneven pattern on the surface thereof with a thickness of between 0.1 µm and 1.5 µm, inclusive, are laminated on a support substrate 3 In addition, if necessary, the stress adjusting layer 5 is provided on the surface (bottom surface) of the supporting substrate 3 opposite the surface on which the planarizing layer 4 is laminated.

The supporting substrate (base substrate) 3 has a core 31 serving as the core material of the supporting substrate 3 and an encapsulating layer 32 covering the core 31.

Preferable materials for the core 31 include nitride ceramics, which have excellent heat resistance and stability and are available in large diameter sizes at low cost. Aluminum nitride (AlN), silicon nitride (SiₐN₄), gallium nitride (GaN), boron nitride (BN), or a mixture of these may be used as the nitride ceramics. AlN is particularly preferable because the lattice constant and coefficient of thermal expansion are close to those of a target group III nitride crystal, making it possible to fabricate a high-quality group III nitride crystal with less deformation. AlN is also preferable because it has high thermal conductivity and is superior in heat transfer in the downstream process, including heating.

The shape and size of the core 31 are preferably configured as a wafer shape with a thickness of 200 to 1000 µm so that it may be included in a regular semiconductor process line. In addition, the surface of the core 31 is preferably mirror-finished so that the asperities of the surface of the supporting substrate 3 may be reduced.

When AlN is used as the core 31, AlN ceramics may be produced in a variety of ways, but it is preferable to use the so-called sheet molding/atmospheric sintering method in which a wafer-like green sheet is fabricated by mixing AlN powder with a sintering agent, an organic binder, a solvent, and the like, and, following the degreasing, the sheet may be sintered and polished under an N₂ atmosphere, with respect to the point that higher productivity may be achieved. The sintering agent may be selected from Y₂O₃, Al₂O₃, CaO, and the like, but it is preferable to include, in particular, Y₂O₃ as a sintering agent because the thermal conductivity of the substrate after sintering is high.

The encapsulating layer 32 is a layer that wraps and encapsulates the entire core without any gaps and has a thickness of between 0.05 um and 1.5 um, inclusive. Such structure may prevent substances originating from the ceramics material of the core 31 from leaking to the exterior of the supporting substrate 3.

For example, if AlN ceramics are used as the core 31, elemental substances originating from AlN and Y₂O₃ (which is added as the sintering agent), or substances incorporated into ceramics as impurities from insulation materials, furnace materials, containers, and the like, used for sintering ceramics may leak out. When such substances leak out of the supporting substrate 3, it is likely that they are incorporated as impurities during the epitaxial growth of the target AlN and become a factor that degrades the quality.

If the thickness of the encapsulating layer 32 is thick, it becomes impossible to withstand the thermal stress between the surface layer and the interior of the encapsulating layer 32 after repeated heating and cooling in the downstream process, and peeling is likely to occur. Therefore, various films may be selected and combined, but it is not desirable if the thickness of the encapsulating layer 32 exceeds 1.5 µm. On the other hand, a thickness of less than 0.05 µm is not sufficient in order to achieve a function of encapsulating substances originating from the core 31. From the above, the thickness of the encapsulating layer 32 is preferably between 0.05 µm and 1.5 µm, inclusive. A film made of silicon nitride (Si₃N₄) is preferable for the material of the encapsulating layer 32 because it has a high effect of encapsulating material substances originating from nitride ceramics.

The encapsulating layer 32 is preferably a dense film because of its higher encapsulation performance. In addition, the encapsulating layer 32 is preferably a film with high purity without any impurities, such as sintering agents. In this way, the encapsulating layer 32 is preferably suppressed from unintended substances originating from the encapsulating layer 32 itself leaking out of the supporting substrate 3.

These high-purity films may be deposited using a deposition method including an MOCVD method, an atmospheric CVD, an LPCVD (low-pressure CVD), and a sputtering method. In particular, the LPCVD method is preferably used because it can form a dense film and has excellent film coverage.

In addition, when silicon nitride is used as a material for the encapsulating layer 32, a film of silicon oxide (SiO₂), silicon oxynitride (SiₓO_{y}N_{z}), or the like may be provided between the encapsulating layer and the core 31 as part of the encapsulating layer in order to improve adhesion between silicon nitride and the core. However, even in this case, in order to avoid peeling, it is preferable to set the total thickness of the encapsulating layer 32 between 0.05 µm and 1.5 um, inclusive.

The planarizing layer 3 with a thickness of between 0.5 µm and 3.0 um, inclusive, is laminated on the encapsulating layer 32 at the upper surface of the supporting substrate 3. By laminating the planarizing layer 4, various voids and asperities caused by the core 31, the encapsulating layer 32, or the like, can be filled, and sufficient smoothness can be obtained for the seed crystal to be transferred. However, if the thickness of the planarizing layer 4 is too thick, it will cause warpage and the like, and this is not desirable. For this reason, the thickness of the planarizing layer 4 is preferably between 0.5 and 3.0 um. That is, if the thickness of the planarizing layer 4 is less than 0.5 µm, it is not desirable because voids and asperities generated in the supporting substrate 3 cannot be sufficiently filled. If the thickness of the planarizing layer 4 is 3.0 um or more, warpage is likely to occur, and so this is not desirable.

A stress-adjusting layer 5 is provided on the surface (bottom surface) of the supporting substrate 3 opposite the upper surface on which the planarizing layer 4 is laminated. The stress adjusting layer 5 cancels the stress generated by laminating the planarizing layer 4 and reduces warpage.

In addition, the planarizing layer 4 only needs to be laminated on one surface (upper surface) on the side of the supporting substrate 3, on which the seed crystal layer 2 is to be laminated, but it may be deposited on both surfaces (top and bottom surfaces) of the supporting substrate or may be deposited so as to cover the entire supporting substrate. In this way, the material laminated on the bottom surface acts as a stress-adjusting layer 5, and the stress caused by the planarizing layer 4 at the top and bottom of the substrate is structurally canceled, thereby further reducing the warpage of the substrate.

In addition, simple substance silicon (e.g., polycrystalline silicon) may be laminated as the stress-adjusting layer 5. In this way, there is an advantage of realizing a composite substrate that is compatible with adsorption and desorption by an electrostatic chuck.

The material of the planarizing layer 4 may be selected from silicon oxide (SiO₂), aluminum oxide (Al₂O₃), silicon nitride (Si₃N₄), silicon carbide (SiC), or silicon oxynitride (SiₓO_{y}N_{z}), silicon (Si), gallium arsenide (GaAs), aluminum arsenide (AlAs), and others. In particular, silicon oxide (SiO₂), silicon oxynitride (SiₓO_{y}N_{z}), and aluminum arsenide (AlAs) are preferable because they are easy to grind and polish when planarizing, and they can easily become a sacrificial layer for separating the supporting substrate 3 after epitaxial growth of the target group III nitride such as AlN.

The deposition of the planarizing layer 4 may be arbitrarily selected, depending on the required film quality and deposition efficiency, from a plasma CVD method or LPCVD method, a low-pressure MOCVD method, or the like. Depending on the condition of the film of the laminated planarizing layer 4, heat treatment of baking and CMP polishing may be applied after deposition in order to prepare for the formation of the seed crystal layer 2.

A seed crystal layer 2 of single crystal made of high-quality Si <111>, SiC, sapphire, aluminum nitride, or aluminum gallium nitride is formed on the planarizing layer 4 formed on the upper surface of the supporting substrate 3. The seed crystal layer 2 has an uneven pattern on the surface thereof. The thickness of the seed crystal layer 2 is preferably between 0.1 µm and 1.5 µm, inclusive. In this way, a high-quality seed crystal layer 2 can be formed. That is, ion implantation peeling may be applied to the single crystal substrate described above in order to transfer a high-quality crystal layer. If the thickness of the seed crystal layer 2 is less than 0.1 µm, the thickness of the layer damaged during ion implantation is substantially close to the thickness of the seed crystal layer, so such a seed crystal layer cannot be a good seed crystal. If the thickness of the seed crystal layer 2 is 1.5 um or more, the ion implantation equipment becomes huge and requires enormous investment, thereby making it impractical.

The high-quality single crystal used in this case is preferably a single crystal obtained by or epitaxially grown by using any of the general melting methods (CZ and FZ methods), a sublimation method, an MOCVD (metal-organic chemical vapor deposition) method, an HVPE (hydride vapor phase epitaxy) method, and a THVPE (trihalide vapor phase epitaxy) method. In addition, it is preferably a crystal with an extremely low dislocation density, with the EPD of the single crystal being 1 × 10⁶ cm⁻² or less.

The uneven pattern on the surface of the seed crystal layer 2 can be formed by lithographically fabricating periodic grooves or dot structures of several µm to several tens of um or by forming 0.1 to 3 degree off-angles by etching or other methods on the surface of Si <111>, SiC, sapphire, aluminum nitride or aluminum gallium nitride after thin film transfer by ion implantation peeling. The pattern is chosen based on the properties of the seed crystal substrate.

The composition of the seed crystal layer 2 does not need to match the composition of the film to be epitaxially grown, but it is preferable that the crystal type be similar and its lattice constant as close as possible to that of AlN. On the other hand, although the thermal expansion coefficient of the seed crystal layer 2 is preferably close to that of AlN, the seed crystal layer 2 is formed extremely thin by thin-film transfer, so its effect on warpage is negligible compared to the base substrate of the core. In contrast, in a thick seed crystal substrate, which serves as both base substrate and seed crystal, if there is a difference in thermal expansion coefficient with the film to be epitaxially grown, the substrate warps significantly during deposition, causing cracks and breaks.

When the seed crystal layer 2 is aluminum nitride or aluminum gallium nitride, it is preferable that the resistivity thereof is 1 × 10⁶ Ω·cm or higher. In this way, impurities incorporated into the target material epitaxially deposited on the seed crystal layer 2 may be reduced, and coloring (i.e., light absorption) of the target material may be suppressed.

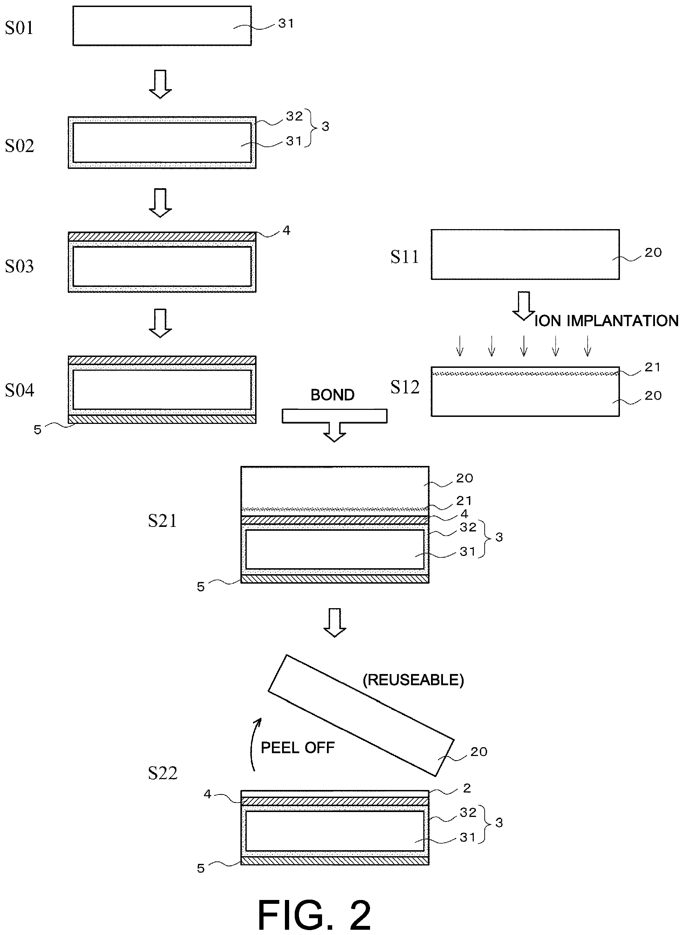

Then, with reference to FIG. 2, the procedure for producing the substrate for group III nitride epitaxial growth according to the embodiment of the present invention will be described. First, the core 31 consisting of nitride ceramics is prepared (S01 in FIG. 2). Next, the encapsulating layer 32 with a thickness of between 0.05 µm and 1.5 um, inclusive, is deposited so as to wrap in the core 31 and the supporting substrate 3 is obtained (S02 in FIG. 2). In this case, the encapsulating layer 32 may be deposited by using an LPCVD method.

Next, the planarizing layer 4 with a thickness of between 0.5 µm and 3.0 µm, inclusive, is deposited on the upper surface of the supporting substrate 3 (S03 in FIG. 2). The planarizing layer 4 may be deposited by using any one of the plasma CVD method, the LPCVD method, and the low-pressure MOCVD method. In addition, the stress-adjusting layer 5 is further deposited on the bottom surface of the supporting substrate 3 (S04 in FIG. 2). The planarizing layer 4 and the stress-adjusting layer 5 may be deposited at the same time.

Apart from S01-S04, a group III nitride single crystal substrate 20 is prepared for peeling transfer of the seed crystal layer 2 (S11 in FIG. 2). The specific technique for preparing this single crystal substrate 20 will be described later. Next, ion implantation is performed from one surface (ion implantation surface) of the single crystal substrate 20, and a peeling position (embrittlement layer) 21 is formed in the single crystal substrate 20 (S12 in FIG. 2). The ions to be implanted are, for example, H⁺, H₂⁺, Ar⁺, He⁺, and the like.

Next, the ion implantation surface of the single crystal substrate 20 is bonded to the planarizing layer 4 formed on the supporting substrate 3 to obtain a bonded substrate (S21 in FIG. 2). Then, the single crystal substrate 20 is separated at the peeling position 21 of the single crystal substrate 20 in the bonded substrate (S22 in FIG. 2). In this way, on top of the planarizing layer 4 on the supporting substrate 3, a single crystal film of Si <111>, a SiC, sapphire, aluminum nitride or aluminum gallium nitride is thinly transferred as the seed crystal layer 2. After separating the seed crystal layer 2 from the remaining section of the single crystal substrate 20 at the peeling position 21, an uneven pattern is provided on the seed crystal layer 2. Through these steps, the supporting substrate 3, the planarizing layer 4, and the seed crystal layer 2 with the uneven pattern are laminated to form a group III nitride composite substrate. On the other hand, the remaining section of the separated group III nitride single crystal substrate 20 can be repeatedly utilized for transferring a seed crystal layer when fabricating another group III nitride composite substrate by polishing the surface again to make an ion implantation surface.

The ion implantation surface of single crystal substrate 20 may be bonded once to a different temporary supporting substrate, such as a silicon wafer, and after separation, the seed crystal layer 2 may be kept bonded to the temporary supporting substrate. After bonding the seed crystal layer 2 on this temporary supporting substrate to the planarizing layer 4, the process of separating the temporary supporting substrate from the seed crystal layer may be performed. In this way, the seed crystal layer 2 bonded to the planarizing layer 4 may be bonded upside down.

Next, the method of preparing a single crystal substrate 20 will be described. For Si<111>, SiC, or sapphire substrates, which are easy to obtain large-diameter substrates as commercially available substrates, the commercially available substrates can be used as they are as the single-crystal substrate 20. On the other hand, for aluminum nitride or aluminum gallium nitride, for which large-diameter substrates are difficult to obtain, a single-crystal large-diameter substrate can be made by laminating aluminum nitride or aluminum gallium nitride on a large-diameter sapphire substrate by MOCVD, HVPE, or THVPE (trihalide vapor phase epitaxy) method. Alternatively, when using a small-diameter substrate fabricated by the sublimation method (sublimation method substrate) or when using a crystal made by laminating aluminum nitride or aluminum gallium nitride by either the MOCVD, HVPE or THVPE method on top of an AlN substrate made by the sublimation method, it is recommended to fabricate a large-diameter substrate by bonding single crystals of small diameters together.

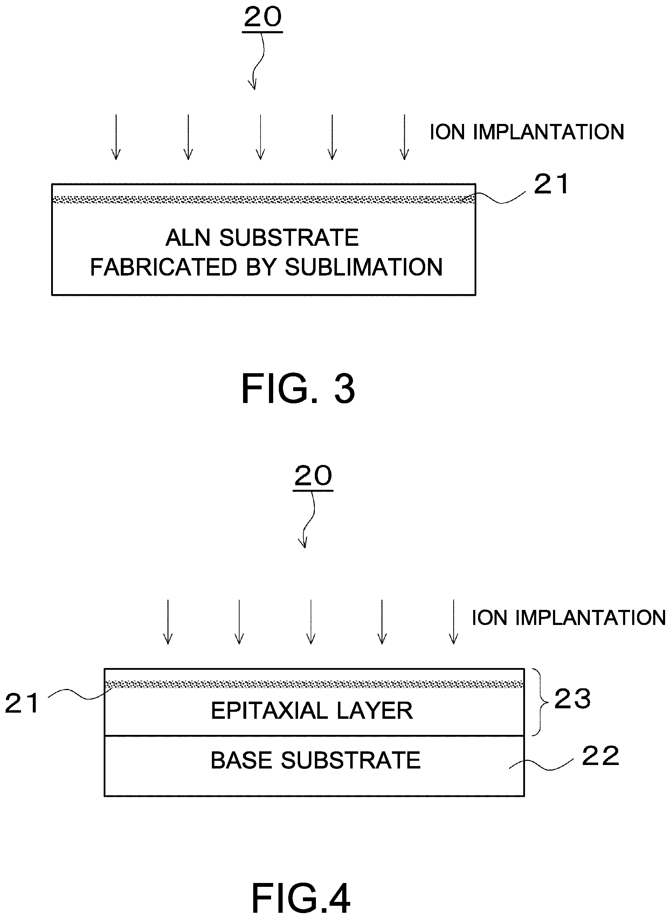

FIG. 3 shows the layer structure of single crystal substrate 20 in the case where ion implantation is performed to a large-diameter substrate which is formed by bonding multiple small-diameter sublimation method substrates in the same orientation. FIG. 4 shows the layer structure of single crystal substrate 20 in the case where the single crystal epitaxial layer substrate obtained by epitaxial deposition on the base substrate 22 by one of the MOCVD, HVPE, or THVPE is used, with the above described bonded substrate as the base substrate 22. In this case, the peeling position 21 obtained by ion implantation may be set within the epitaxial layer 23. In this way, a seed crystal layer 2 can be formed without consuming the expensive AlN substrate fabricated by using the sublimation method, thereby reducing the production cost. In addition, when epitaxially depositing an AlₓGa₁₋ₓN single crystal by using any of the methods including the MOCVD method, the HVPE method, and the THVPE method, there is an advantage to the effect that an optimum value for epitaxial growth in the target downstream process can be selected because the value of x of AlₓGa₁₋ₓN may be varied between 0 ≤ x ≤ 1 by adjusting the source gas composition, and the like.

AlN substrates fabricated by the sublimation method are generally smaller in diameter, more expensive, and more easily colored but have superior crystalline characteristics. As shown in FIG. 3, a large-diameter substrate is fabricated by bonding a plurality of small-diameter single crystals, followed by ion implantation to perform a thin-film transfer with a thickness of 0.1 µm to 1.5 um. The remaining section of the single-crystal substrate can be reused repeatedly by reusing it in the fabrication of the next composite substrate, thereby reducing the cost of fabricating composite substrates, and it also functions as an extremely good seed crystal. In addition, since the sublimation method substrate is not used as a thick substrate of several hundred micrometers as in the past but as a very thin film of 0.1 µm. to 1.5 µm by thin-film transfer, coloring like that of the original substrate is not a problem.

Further, if the peeling position is set within the epitaxial layer as shown in FIG. 4, the remaining section of the single crystal epitaxial layer substrate remained after the performance of the transfer with a thickness of between 0.1 µm and 1.5 µm may be reused for fabricating the next composite substrate. In this way, the single crystal epitaxial layer substrate can be used repeatedly, thereby significantly reducing the cost of fabricating composite substrates. In addition, if an epitaxial layer is regenerated by using, as a base substrate, the remaining section of the single crystal epitaxial layer substrate having a thinned-out epitaxial layer portion as a result of repeated use, and by epitaxially depositing an epitaxial layer by using any of the methods including the MOCVD method, the HVPE method, and the THVPE method, the initial substrate can be used repeatedly, thereby further reducing the fabrication cost.

### EXAMPLES

The present invention will be described more specifically hereinafter by citing examples and comparative examples below, but the present invention is not limited to these examples.

### [Example 1]

### (Preparation of Supporting Substrate)

(1) An AlN substrate (AlN polycrystalline ceramics substrate), which is polished on both surfaces and has a diameter (φ) of 8 inches and a thickness (t) of 725 µm, was used as the core. Such substrate was obtained by mixing 100 parts by weight of AlN powder and 5 parts by weight of Y₂O₃ (a sintering agent) with an organic binder, a solvent, and the like, to create a green sheet, and, following the degreasing, sintering the sheet under an atmosphere of N₂ at a temperature of 1900°C. (2) A supporting substrate was obtained by wrapping in the entire core with a 0.2 µm thick silicon oxynitride layer by using the LPCVD method, wrapping, on top thereof, the entire thing with a 0.6 um thick silicon nitride (Si₃N₄) layer using further different LPCVD equipment, and encapsulating the entire thing (the total thickness of the encapsulating layer is 0.8 µm).

### (Lamination of Planarizing Layer)

For the purpose of planarization, a 7 um thick SiO₂ was further laminated on the Si₃N₄ layer on one surface (upper surface) of the supporting substrate by using the plasma CVD method (ICP-CVD equipment). The SiOz was then baked at 1000°C and polished and planarized to a thickness of 3 µm by CMP polishing, resulting in a surface roughness of Ra = 0.15 nm.

### (Preparation of Seed Crystal)

Ion implantation of hydrogen was carried out on the commercially available φ 8-inch Si <111> substrate pulled up by the CZ method at 100 keV, at a depth of 0.7 um (peeling position), and with a dose of 6 × 10¹⁷ cm⁻². The ion implantation surface of the AlN single crystal substrate after ion implantation was bonded with the planarizing layer of the supporting substrate prepared earlier. After that, the seed crystal layer of the AlN single crystal was transferred to the supporting substrate by peeling and separation at the peeling position (at 0.7 µm). The section of the Si single crystal in the seed crystal layer, which was damaged during ion implantation and transfer, was lightly polished with CMP, and the thickness of the Si seed crystal layer was set to 0.5 um. A periodic uneven pattern with a groove depth of 0.3 um, a groove width of 3 µm, and a terrace width of 5 µm was formed on this Si seed crystal layer. The remaining section of the Si single crystal substrate after the transfer (i.e., the section that was peeled and separated without being transferred to the supporting substrate) could be utilized as multiple seed crystals by repeatedly carrying out ion implantation, making it extremely economical. According to the above processes, an φ 8-inch substrate for group III nitride epitaxial growth was obtained, in which a 3 um thick planarizing layer and a 0.5 um thick Si<111> seed crystal layer were provided on the supporting substrate having the structure of (1) an AlN ceramics core and (2) an encapsulating layer.

### (Evaluation of Substrate)

Next, the following simple evaluation regarding adequacy as a substrate for AlN epitaxial growth was further performed on the above-described substrate. More specifically, 2 µm of AlN was deposited on the substrate for AlN epitaxial growth using the MOCVD method, and in order to evaluate the dislocation density, the etch pit density (hereinafter referred to as "EPD") was measured by generating etch pitches by the molten alkali (KOH + NaOH) etching method. In addition, X-ray rocking curve (XRC) measurements were performed to evaluate the crystallinity. As a result, the EPD showed an extremely low dislocation density of 3 × 10⁵ cm⁻². The XRC measurements on a (0002) plane of the substrate yielded a half-value width FWHM of 321 arcsec, resulting in a high-quality AlN single crystal. These results indicate that the substrate for epitaxial growth according to the present example is superior.

### [Comparative Example 1]

All conditions were the same as in Example 1, except that the Si seed crystal layer was flat Si <111> without the uneven pattern. Thereby, an φ 8-inch substrate for group III nitride epitaxial growth was obtained, in which a 3 um thick planarizing layer and a 0.5 um thick Si<111> seed crystal layer were provided on the supporting substrate having the structure of (1) an AlN ceramics core and (2) an encapsulating layer.

### (Evaluation of Substrate)

Next, the following simple evaluation regarding adequacy as a substrate for AlN epitaxial growth was further performed on the above-described substrate. That is, 2 µm AlN was deposited on the substrate for AlN epitaxial growth by the MOCVD method, and to evaluate dislocation density, etch pits were generated by molten alkali (KOH + NaOH) etching method, and EPD was measured. In addition, XRC measurements were performed to evaluate the crystallinity. As a result, the EPD showed an extremely low dislocation density of 3 × 10⁶ cm⁻². The XRC measurements on a (0002) plane of the substrate yielded a half-value width FWHM of 731 arcsec, and the crystal was inferior to Example 1 in both dislocation density and half-value width.

### [Example 2]

### (Preparation of Supporting Substrate)

An AlN polycrystalline ceramics substrate having (1) a core similar to that of Example 1 was used as the structure of a supporting substrate. Then, (2) as an encapsulating layer, the entire AlN ceramics core was first wrapped in a 0.5 um thick SiO₂ layer by using the LPCVD method, and then, on top of which, the entire thing was encapsulated with a 0.8 um thick Si₃N₄ layer using further different LPCVD equipment (the total thickness of the encapsulating layer was 1.3 µm) in order to form the supporting substrate.

### (Lamination of Planarizing Layer and Stress Adjusting Layer)

For the purpose of planarization, 4 µm of silicon oxynitride was further laminated on the Si₃N₄ layer on one surface (upper surface) of the supporting substrate by using the LPCVD method. After that, the silicon oxynitride layer was CMP polished to a thickness of 3 um. The entire substrate showed a warpage of about 30 µm. In order to correct the warpage, silicon oxynitride was laminated on the bottom surface to a thickness of 5 µm by using the LPCVD method to obtain a stress-adjusting layer. After that, 0.2 um of polycrystalline Si was further added by using the LPCVD method so as to be compatible with adsorption and desorption by an electrostatic chuck. As a result, the warpage was eliminated, and the electrostatic chuck was able to be attached and detached.

### (Preparation of Seed Crystal)

An AlN crystal used as a seed crystal was created by using a sublimation method (improved Rayleigh method) according to the following procedure. First, a TaC crucible was placed in a highly purified graphite growth container, a high-purity AlN raw material was provided at the bottom of the TaC crucible, and an AlN crystal was provided at the top. The growth container and the crucible were heated by high-frequency induction heating, the raw material was kept at 2000°C, the raw material was decomposed through sublimation, and AlN single crystals were precipitated on the AlN crystal at the top. This AlN single crystal was sliced and polished to form a smooth φ 2-inch substrate with a thickness of 200 µm. The resistivity was measured at eight equal spacing points on the surface of the substrate, and the resistivity was measured from 1 × 10⁶ Ω·cm to 3 × 10¹¹ Ω·cm. The light transmissibility of the 230 nm wavelength was 0.2% at a thickness of 100 um.

The φ 2-inch substrates prepared above were made into regular hexagonal AlN substrates, and several of these substrates were bonded to a φ 8-inch quartz substrate by matching their orientations. The quartz substrate was then trimmed by cutting the excess portion around the periphery to form a φ 8-inch substrate. Ion implantation of hydrogen was carried out on the φ 8-inch AlN single-crystal substrate prepared in this way at 100 keV, at a depth of 0.6 um (peeling position), and with a dose of 8 × 10¹⁷ cm⁻². The ion implantation surface of the AlN single crystal substrate after ion implantation was bonded with the planarizing layer of the supporting substrate prepared earlier. After that, the seed crystal layer of the AlN single crystal was transferred to the supporting substrate by peeling and separation at the peeling position (section at 0.6 µm). The section of the AlN single crystal in the seed crystal layer, which was damaged during ion implantation and transfer, was lightly polished with CMP, and the thickness of the AlN crystal layer was set to 0.4 um.

Off-angles of 0.2° were formed on this seed crystal layer by etching. The original substrate of this AlN seed crystal layer was strongly colored and had extremely low light transmittance at a wavelength of 230 nm as described above, but because the thin film was used as the seed crystal as explained in the embodiment of the invention, no coloring was observed in the seed crystal, and the light transmittance at 230 nm was 99.9%. The remaining section of the AlN single crystal substrate after the transfer (i.e., the section that was peeled and separated without being transferred to the supporting substrate) could be utilized as multiple seed crystals by repeatedly carrying out ion implantation, making it extremely economical. Thereby, a φ 8-inch substrate for group III nitride epitaxial growth was obtained, in which a 2 um thick planarizing layer and a 0.4 um thick AlN seed crystal layer were provided on the supporting substrate having the structure of (1) an AlN ceramics core and (2) an encapsulating layer.

### (Evaluation of Substrate)

Next, similar to Example 1, the group III nitride substrate for epitaxial growth obtained in this example was briefly evaluated as a substrate for AlN epitaxial growth. More specifically, 2 um of AlN was deposited on the substrate for AlN epitaxial growth using the MOCVD method, and in order to evaluate the dislocation density, the EPD was measured by using the molten alkali (KOH + NaOH) etching method. In addition, XRC measurements were performed to evaluate the crystallinity. As a result, the EPD showed an extremely low dislocation density of 2.3 × 10⁴ cm⁻². The XRC measurements on a (0002) plane of the substrate yielded a half-value width FWHM of 132 arcsec, resulting in a high-quality AlN single crystal. These results indicate that the substrate for epitaxial growth according to the present example is superior.

### [Comparative Example 2]

The same conditions were used as in Example 2, except that the thin film was used as the seed crystal layer without forming an off-angle at all after the AlN crystal thin film was transferred. 2 um of AlN was deposited on this substrate for epitaxial growth by MOCVD as in Example 2 and evaluated. The resulting EPD was 6.5 × 10⁶cm⁻². In addition, the FWHM yielded in the XRC measurements on the (0002) plane of the substrate was 1950 arcsec, and the crystal quality was considerably inferior to that of Example 2. In order to increase the size of the seed substrate, multiple AlN substrates were used and bonded together with the same orientation, but it is considered that slight differences in crystal orientation had a negative impact on crystal growth. On the other hand, in Example 2, the uneven pattern on the surface of the seed crystal layer is actively provided, which is thought to compensate for these negative effects on crystal growth, such as crystal defects and subtle misorientation. The substrate obtained from this comparison example had poor crystallinity and was unsuitable as an epitaxial substrate for growing group III nitride single crystal for deep UV applications.

### [Comparative Example 3]

The top layer of a C-plane, φ 8-inch sapphire substrate (725 um thick), which served as both base and seed substrates, was etched to form a 0.2° off-angle, and used as the substrate for epitaxy. 2 um of AlN was deposited on this substrate by MOCVD as in Example 2 and evaluated. The resulting EPD was 5 × 10⁷cm⁻². In addition, the FWHM yielded in the XRC measurements on the (0002) plane of the substrate was 2500 arcsec, and the crystal quality was considerably inferior to that of Example 2. In addition, the entire substrate after deposition warped so much that it could not be vacuumed by the vacuum chuck, and subsequent device processing could not be performed.

### [Example 3]

The same conditions as in Example 1 were used except for the point that the planarizing layer was changed from SiO₂ with a thickness of 3 µm to AlAs with a thickness of 2 µm. As a result, a substrate for group III nitride epitaxial growth was obtained, in which a 2 um thick AlAs planarizing layer and a 0.5 µm thick Si<111> seed crystal layer are provided on the supporting substrate having the structure of (1) an AlN ceramics core and (2) an encapsulating layer. 50 mm of AlN was further laminated on this group III nitride epitaxial growth substrate by using the HVPE method. The laminate was immersed in a 25% HCl aqueous solution to dissolve the AlAs layer and separate the 50 mm AlN crystal from the supporting substrate. Cylindrical grinding, slicing, and polishing of this AlN crystal resulted in 50 solid φ 8-inch AlN single-crystal substrates.

Next, the same simple evaluation as that in Example 1 regarding adequacy as a substrate for AlN epitaxial growth was performed on the above-described substrate. As a result, the EPD showed an extremely low dislocation density of 5.0 × 10⁴ cm⁻². The XRC measurements on a (0002) plane of the substrate yielded FWHM of 132 arcsec, and high-quality AlN single crystals were obtained. Further, no coloring was observed, and the light transmissibility at the 230 nm wavelength was good at about 90%, making it suitable as a device substrate for the deep ultraviolet range.

As described above, according to the present invention, a substrate for group III nitride epitaxial growth, which is capable of fabricating a high-quality and large-diameter group III nitride single crystal, can be provided at a low cost.

### REFERENCE SIGNS LIST

- 1: Composite substrate
- 2: Seed crystal layer
- 3: Supporting substrate
- 4: planarizing layer
- 5: Stress adjusting layer
- 20: Single crystal substrate of group III nitride
- 21: Peeling position
- 22: Base substrate
- 23: Epitaxial layer

## Claims

1. A substrate for group-III nitride epitaxial growth comprising:
a supporting substrate having a structure in which a core consisting of nitride ceramics is wrapped in an encapsulating layer having a thickness of between 0.05 um and 1.5 µm, inclusive;
a planarizing layer provided on an upper surface of the supporting substrate, the planarizing layer having a thickness of between 0.5 um and 3.0 um, inclusive; and
a seed crystal layer consisting of a single crystal with a thickness of between 0.1 um and 1.5 µm, inclusive, provided on an upper surface planarizing layer and having an uneven pattern on the surface thereof.

2. The substrate for group-III nitride epitaxial growth according to claim 1, wherein the substrate further comprises a stress-adjusting layer on the bottom surface of the supporting substrate.

3. The substrate for group-III nitride epitaxial growth according to claim 1 or 2, wherein the core is aluminum nitride ceramics.

4. The substrate for group-III nitride epitaxial growth according to any one of claims 1 to 3 wherein the encapsulating layer contains silicon nitride.

5. The substrate for group-III nitride epitaxial growth according to any one of claims 1 to 4, wherein the planarizing layer contains any one of silicon oxide, silicon oxynitride, and aluminum arsenide.

6. The substrate for group-III nitride epitaxial growth according to any one of claims 1 to 5, wherein the seed crystal layer is Si<111>, SiC, aluminum nitride, or aluminum gallium nitride.

7. The substrate for group-III nitride epitaxial growth according to any one of claims 1 to 6, wherein the uneven pattern is selected from periodic grooves, off-angles of 0.1 to 3°, and dot structures.

8. The substrate for group-III nitride epitaxial growth according to any one of claims 1 to 7, wherein the seed crystal layer is aluminum nitride or aluminum gallium nitride, and resistivity of the seed crystal layer is 1 × 10⁶ Ω·cm or more.

9. The substrate for group-III nitride epitaxial growth according to claim 2, wherein the stress adjusting layer contains simple substance silicon.

10. A method for producing a substrate for group-III nitride epitaxial growth comprising steps of:
preparing a core consisting of nitride ceramics;
obtaining a supporting substrate by depositing an encapsulating layer so as to wrap the core, the encapsulating layer having a thickness of between 0.05 um and 1.5 µm, inclusive;
depositing a planarizing layer on an upper surface of the supporting substrate, the planarizing layer having a thickness of between 0.5 um and 3.0 µm, inclusive; and
providing a seed crystal layer consisting of a single crystal with a thickness of between 0.1 µm and 1.5 µm, inclusive, provided on an upper surface planarizing layer and having an uneven pattern on the surface.

11. The method for producing a substrate for group-III nitride epitaxial growth according to claim 10, wherein the method further comprises a step of depositing a stress-adjusting layer on the bottom surface of the supporting substrate.

12. The method for producing a substrate for group-III nitride epitaxial growth according to claim 10 or 11, wherein the encapsulating layer is deposited by using an LPCVD method.

13. The method for producing a substrate for group-III nitride epitaxial growth according to any one of claims 10 to 12, wherein the planarizing layer is deposited by using any one of a plasma CVD method, an LPCVD method, and a low-pressure MOCVD method.

14. The method for producing a substrate for group-III nitride epitaxial growth according to any one of claims 10 to 13, wherein the step of providing the seed crystal layer includes the steps of:
preparing a single crystal substrate of a group III nitride, one surface of the single crystal substrate being an ion implantation surface;
forming a peeling position in the single crystal substrate by performing ion implantation from the ion implantation surface;
obtaining a bonded substrate by bonding the ion implantation surface and the planarizing layer;
separating the bonded substrate into the seed crystal layer and a remaining section of the single crystal substrate at the peeling position; and
providing the uneven pattern on the seed crystal layer obtained in the step of separating.

15. The method for producing a substrate for group III nitride epitaxial growth according to claim 14, wherein, in the step of preparing the single crystal substrate, the single crystal substrate of aluminum nitride or aluminum gallium nitride is obtained by epitaxially growing an epitaxial layer of aluminum nitride or aluminum gallium nitride by using any one of an MOCVD method, an HVPE method, and a THVPE method on a sapphire substrate.

16. The method for producing a substrate for group III nitride epitaxial growth according to claim 14, wherein, in the step of preparing the single crystal substrate, the single crystal substrate is obtained by bonding small-diameter single crystals made by epitaxial growth of an epitaxial layer of aluminum nitride or aluminum gallium nitride by using any one of an MOCVD method, an HVPE method, and a THVPE method on a substrate of small-diameter single crystal made by the sublimation method or on an AlN substrate made by the sublimation method.

17. The method for producing a substrate for group-III nitride epitaxial growth according to claim 15 or 16, wherein, in the step of forming the peeling position, the peeling position is formed within the epitaxial layer.

18. The method for producing a substrate for group-III nitride epitaxial growth according to claim 16 or 17, wherein the remaining section of the single crystal substrate is reused as the base substrate.

19. The method for producing a substrate for group-III nitride epitaxial growth according to any one of claims 14 to 18, wherein the remaining section of the single crystal substrate is reused as a single crystal substrate in the production of a further different group III nitride composite substrate.

20. The method for producing a substrate for group-III nitride epitaxial growth according to any one of claims 10 to 19, wherein the core is aluminum nitride ceramics.

21. The method for producing a substrate for group-III nitride epitaxial growth according to any one of claims 10 to 20, wherein the encapsulating layer contains silicon nitride.

22. The method for producing a substrate for group-III nitride epitaxial growth according to any one of claims 10 to 21, wherein the planarizing layer contains any one of silicon oxide, silicon oxynitride, and aluminum arsenide.

23. The method for producing a substrate for group-III nitride epitaxial growth according to any one of claims 10 to 22, wherein the seed crystal layer is Si<111>, SiC, aluminum nitride, or aluminum gallium nitride.

24. The method for producing a substrate for group-III nitride epitaxial growth according to any one of claims 10 to 23, wherein the uneven pattern is selected from periodic grooves, off-angles of 0.1 to 3°, and dot structures.

25. The method for producing a substrate for group-III nitride epitaxial growth according to any one of claims 10 to 24, wherein the seed crystal layer is aluminum nitride or aluminum gallium nitride, and resistivity of the seed crystal layer is 1 × 10⁶ Ω·cm or more.

26. The method for producing a substrate for group III nitride epitaxial growth according to claim 11, wherein the stress adjusting layer contains simple substance silicon.
